# EUROPEAN PATENT APPLICATION

(11) **EP 2 541 768 A1**
(43) Date of publication of application: **02.01.2013**
(21) Application number: 11172130.4
(22) Date of filing: 30.06.2011
(51) Int. Cl.: H03H 5/02, H04B 3/56

(54) **Bypass for bypassing a high frequency power line communication signal**

(71) Applicant: ABB Research Ltd., 8050 Zürich (CH)
(72) Inventor: Smajic, Jasmin, 8165 Schöfflisdorf (CH); Dzung, Dacfey, 5430 Wettingen (CH); von Hoff, Thomas, 5443 Niederrohrdorf (CH)
(74) Representative: ABB Patent Attorneys

(57) **Abstract**

A bypass (14) for bypassing a high frequency signal (24), for example a power line communication signal, around an electrical power component (12) coupling a first power line (16) and a second power line (18) comprises at least one resonant circuit (28,30) with an inductor L₃ and a capacitor C₃. The resonant circuit (28,30) is electrically coupled with the first power line (16) and the second power line (18) and galvanically separates the first power line (16) from the second power line (18). Furthermore, the resonant circuit (28,30) is tuned to a high frequency range different from a line frequency, such that the high frequency signal (24) is transmitted by the bypass (14).

## Description

### FIELD OF THE INVENTION

The invention relates to the field of power line communication. In particular, the invention relates to a high frequency bypass for bypassing a transformer and a system comprising a bypass bypassing a power transformer.

### BACKGROUND OF THE INVENTION

Nowadays nearly almost all buildings are connected to a power grid that provides electrical energy. The already present infrastructure, i.e. the conducting power lines of the power grid, may additionally be used for data communication without the need for further electrical lines. Such a data communication over already present power lines may be called power line communication.

For power line communication with high data rate, high frequency bands well above the AC power frequency of 50 or 60 Hz may be used. However, power transformers are usually designed for transmission at AC power frequencies, but may block transmission of power line communication signals, which are typically in the range above 20 kHz.

Where power line communication is desired across power networks on different voltage levels, this signal blocking is undesired, for example between low voltage and medium voltage networks. Such blocking may be circumvented by using by-pass units or bridges. According to application requirements, by-pass units may be composed of either passive devices (which may directly by-pass the electric communication signals resulting in a single communication network on both medium voltage and low voltage levels) or active devices (which may receive, regenerate, and re-transmit data packets between two independent communication networks on medium voltage and low voltage levels).

Modem power systems and their components are usually designed to have very efficient power transmission capabilities at 50Hz. However, the efficiency radically decreases for frequencies above 50Hz. This effect is mainly attributed to power transformers due to the hysteresis and eddy-current losses in magnetic cores, parasitic capacitances between the windings and the ground, and skin effects and proximity effects in the winding conductors. In particular, hysteresis losses are proportional to the frequency, Eddy-current losses are a complex function of the square of the frequency and skin-effect and proximity effect are essentially caused by eddy-currents and therefore have the same frequency dependence, a complex function of the square of the frequency. Thus, a common feature of the transformer losses is their increase with the frequency, which may explain the poor high frequency transmission capabilities of transformers.

On the other hand, it may be very useful to use transmission lines of power systems to transmit high frequency control and protection signals. However, due to the high frequency transmission losses, the existing applications are very limited and are usually based on a brute force approach, namely, for very modest outputs, inputs several orders of magnitude larger are required.

### DESCRIPTION OF THE INVENTION

There may be a need for a high frequency bypass for a power transformer and other electrical power components with poor high frequency transmission capabilities that is capable of reducing the high frequency transmission losses. In such a way, a bidirectional high frequency communication between utilities and consumers may be more efficient and more reliable.

The object of the invention is to provide such a bypass.

This object is achieved by the subject-matter of the independent claims. Further exemplary embodiments are evident from the dependent claims and the following description.

A first aspect of the invention relates to a high frequency bypass for bypassing a transformer operating at a line frequency and coupling a first power line and a second power line. The high frequency signal may be a power line communication signal.

The bypass may also be used to bypass an electrical power component that may be a reactor, a GIS substation, a converter, etc. In particular, the electrical power component may be a high power component, i.e. a component for processing currents with more than 100 A and/or more than 1000 V.

The bypass comprises a resonant circuit comprising an inductor, for example a coil, and a capacitor. The resonant circuit may further comprise a resistor. The resonant circuit may be adapted to be electrically coupled with the first power line and the second power line and may provide a galvanic isolation between the first power line and the second power line. In particular, a coil inductively coupled to one of the power lines or to a further coil of a further resonant circuit may be used for galvanically separating the two power lines.

The resonant circuit may be tuned to a high frequency range above the line frequency. The line frequency may be 50 Hz or 60 Hz. The high frequency range may have a lower bound of 10 kHz and/or may have an upper bound of 500 kHz. Also, a high frequency may be in this range. The resonant circuit may be tuned by choosing the values of the inductor, the capacitor and the resistor.

The bypass, which may be seen as a passive device, may be able to transmit the high frequency signal in such a way that the output signal leaving the bypass is not damped more than 10dB with respect to the input signal entering the bypass.

The bypass may only comprise passive circuits to allow high frequency bypassing of power transformers.

A further aspect of the invention relates to a system for transmission of electrical energy and for data communication.

The system comprises a power transformer interconnecting a first power line and second power line and adapted for transforming a first voltage in the first power line into a second voltage in the second power line.

The system further comprises a bypass as described in the above and in the following which interconnects the first power line and the second power line and transmits a high frequency data signal between the first power line and the second power line.

For a multi-phase system, the bypass may be connected in parallel with the power transformer, or in general an electrical power component, for one phase, for each single phase or between different phases.

The high frequency bypass may have the following advantages: It may be self powered, i.e. a passive device. It may provide a galvanic insulation between the input and output side, i.e. between the first power line and the second power line. It may provide bidirectional data communication, i.e. from the first power line to the second power line and from the second power line to the first power line.

Furthermore, the bypass may be easy integrated into an existing electrical power component, for example a power transformer. Because standard components may be used, the bypass may be compact, cheap, mechanically stable and robust.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig.1 schematically shows a system with a bypass according to an embodiment of the invention.
Fig.2 shows a circuit diagram of system with a bypass according to an embodiment of the invention.
Fig. 3 shows a diagram indicating the attenuation properties of the system of Fig. 2.
Fig. 4 shows a pair of coils for a bypass according to an embodiment of the invention.
Fig. 5 shows a further pair of coils for a bypass according to a further embodiment of the invention.
Fig. 6 shows a system with a bypass according to a further embodiment of the invention.
Fig. 7 shows a system with a bypass according to a further embodiment of the invention.
Fig. 8 shows a system with a bypass according to a further embodiment of the invention.

In principle, identical or similar parts are provided with the same reference symbols in the figures.

### DETAILED DESCRIPTION OF EXEMPLARY EMBODIMENTS

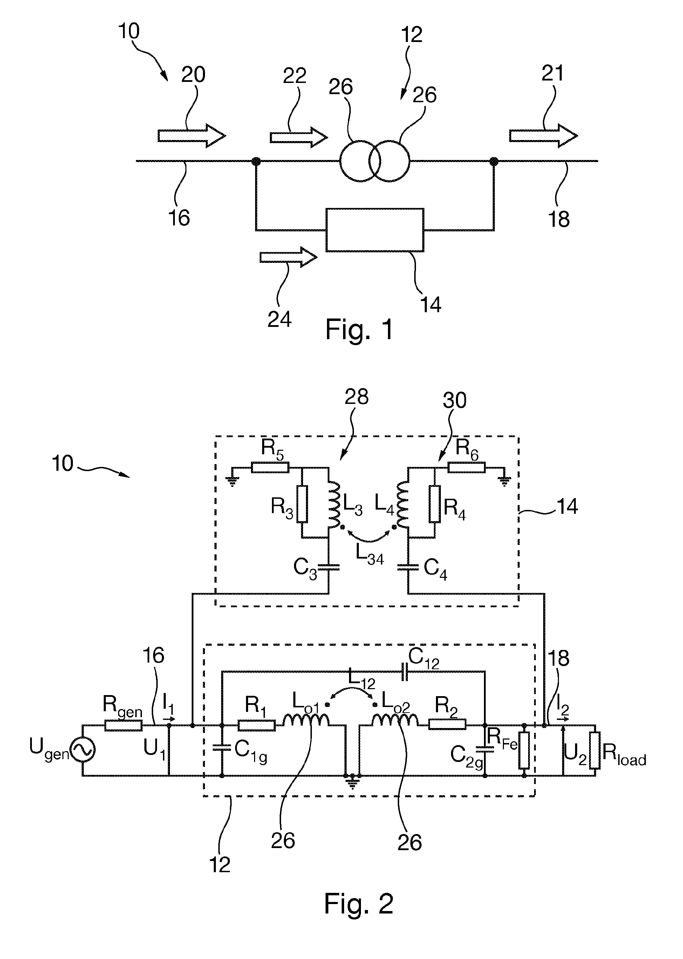

Fig.1 shows a system 10 with a transformer 12 and a bypass 14 that is connected in parallel to the transformer 12. Both transformer 12 and bypass 14 interconnect a first power line 16 and a second power line 18.

A composite signal 20 comprising a low frequency signal 22 (for electrical power transmission) and a high frequency signal 24 (for data communication) enters the system 10 over the first power line 16. The low frequency signal 22, usually a 50Hz "signal" is transmitted via the transformer 12. However, the transformer 12 has a weak high frequency transmission capacity. The parasitic capacitances of both windings 26 against the ground are usually the main reason for the weak high frequency transmission capabilities, because they transfer the high frequency signal directly to the ground.

The high frequency signal 24, which may have a low voltage with respect to the high voltage of the low frequency signal 22, is transferred through the bypass 14.

The composite signal 21 that is recreated after the transformer 12 in the second power line 18 may have both components 22, 24 equally well transmitted. It has to be noted that the composite signals 20, 21 may be on different voltage levels. For example, the signal 21 may be a medium voltage signal and the signal 20 may be a high voltage signal.

Fig. 2 shows a circuit diagram of a system 10 with a high frequency bypass 14 bypassing a power transformer 12. The transformer 12 and the power lines 16, 18 are depicted with equivalent circuit diagrams.

The bypass 14 comprises the two inductors L₃, L₄ that may be two coils L₃, L₄. The coils L₃, L₄ are magnetically coupled and are at the same time parts of two serial resonant circuits 28, 30. The resonant circuit 28 comprises the capacitor C₃, the coil L₃, and the resistors R₃ and R₅. The resonant circuit 30 comprises the capacitor C₄, the coil L₄, and the resistors R₄ and R₆. The capacitor C₃, the coil L₃ and the resistor R₅ are connected in series. The capacitor C₃ is connected to the first power line 16. The resistor R₅ is connected to the ground. Due to the magnetic coupling between the coils L₃, L₄ there is no galvanic connection between the first and second resonant LC circuits 28, 30.

The resonant circuit 30 has circuit that is symmetric to the circuit of the resonant circuit 28. The resonant circuits 28, 30 are inductively coupled via the coils L₃, L₄.

To achieve an ideally linear signal transmission, the magnetic coupling L₃₄ between the coils L₃, L₄ may be achieved through air and not by using a magnetic core. However, the magnetic coupling L₃₄ may be increased by using ferrite cores or ferrite cylinders.

With the magnetic coupling of the coils L₃, L₄ via air, the leakage inductances of the coils L₃, L₄ may be rather high, for example comparable to the mutual inductance between the coils L₃, L₄. This may significantly reduce the transmission efficiency of the bypass 14 due to the voltage drop across the leakage inductances. To circumvent this, each of the two magnetically coupled coils L₃, L₄ are connected in series with the capacitor C₃, C₄. The voltage drop across the capacitor C₃, C₄ has an opposite sign compared to the voltage drop across the inductor L₃, L₄ and, in the case of resonance, the voltage drops may cancel each other perfectly. Thus, the total voltage across the series LC branch C₃, L₃ (and the series LC branch C₄, L₄) will be fully acting on the mutual inductance L₃₄, and is being efficiently transmitted to the secondary side.

This resonance/transmission mechanism is efficient not only exactly at the resonance frequency of the LC branches but also over a certain frequency range around the resonance as long as the voltage drops across the capacitor C₃, C₄ and inductor L₃, L₄ are close enough.

To tune the quality factor of the resonant LC branches, i.e. to make the voltage curves less sharp at resonance (covering wider frequency range) additional resistors R₃, R₄, R₅, R₆ may be used. The resistors R₃, R₄, R₅, R₆ may be seen as tuning elements for the adjustment of the transmission properties.

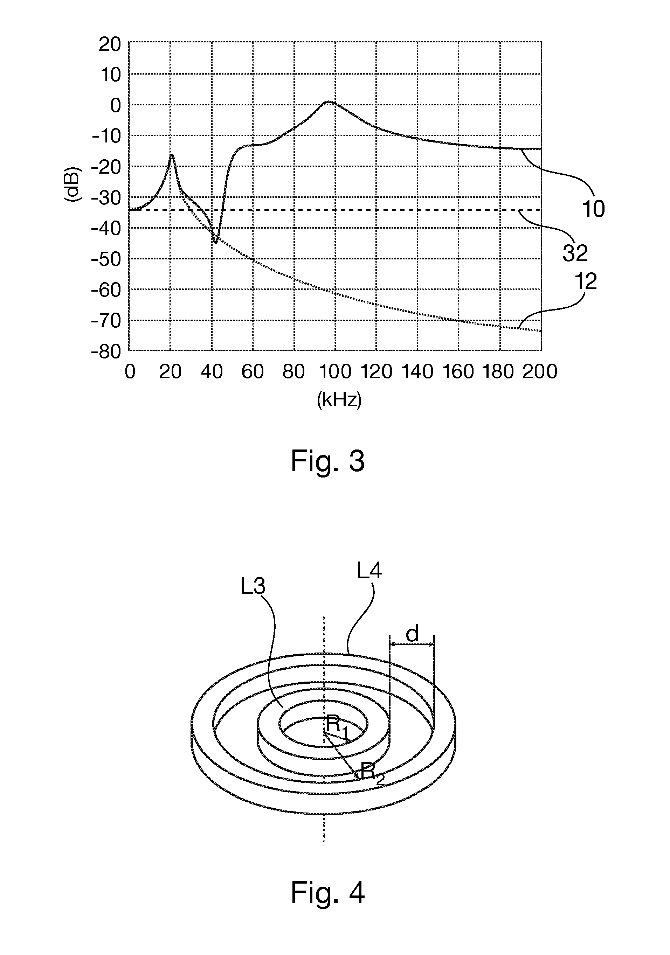

Fig. 3 shows a diagram indicating the attenuation properties of the system 10 of Fig. 2. The curve 10 has been calculated by a simulation of the system 10. The curve 12 has been calculated by a simulation of the transformer 12 without the bypass 14. The curve 32 has been calculated by a simulation of an ideal transformer 32. In the diagram, the x-axis shows the frequency in kHz and the y-axis scalar logarithmic gain in dB.

The simulation has been made for a high frequency bypass 14 that has the following elements: L₃ = L₄ = 80 µH, k₃₄ = 0.5, C₃ = C₄ = 70 nF, R₃ = R₄ = 300 Ω, and R₅ = R₆ = 2 Ω.

The comparison of solid curve 10 and dotted curve 12 (for the real transformer 12) reveals a difference of more than -70 dB which confirms the efficiency of the system 10.

The transmitted high frequency signal 24 may have an acceptable amplitude in the wide frequency spectrum starting with 50 kHz and ending with 180 kHz or even more. The system 10 has excellent transmission capabilities around the resonance peak (80 kHz to 120 kHz) with the scalar logarithmic gain above -10dB. Compared to the transmission capabilities of the transformer 14 our solution offers a gain of at least 70 dB.

A closer look at the solid curve 10 reveals several important details:

In the frequency region of 0 to 50 kHz there is one sharp peak and one sharp dip. The peak is visible also in the dotted curve 12 (for the real transformer) but the dip is not. This means that the peak is a result of the internal resonance of the transformer 12 and the dip corresponds to the interaction between the bypass 14 and the transformer 12. Both effects may be not favorable for a real application since they may be transformer dependant. Therefore the operating frequency (i.e. the high frequency range) of the high frequency system should be above the frequency range below 50 kHz to ensure generality and robustness of our solution. Thus, a recommended high frequency range of the high frequency communication system 10 may be 50 kHz to 200 kHz, where there may be no strong interaction of the bypass 14 with the adjacent power transformer 12.

In the frequency range above 50 kHz there is a nice behavior of the system 10 with a very obtuse peak defined by the resonant frequency of the series LC circuits 28, 30. The position of the peak, i.e. the central frequency of the range of excellent transmission could be easily controlled by the inductances and capacitances of the bypass 14.

The level of the output signal over the entire high frequency range depends mainly on the number of turns of our coils L₃, L₄ and their coupling coefficient k₃₄. Hence it could be easily controlled.

The level of the output signal, and the covered frequency range may be easily adjusted by changing the coils L₃, L₄ itself and mutual inductances (geometry and number of turns).

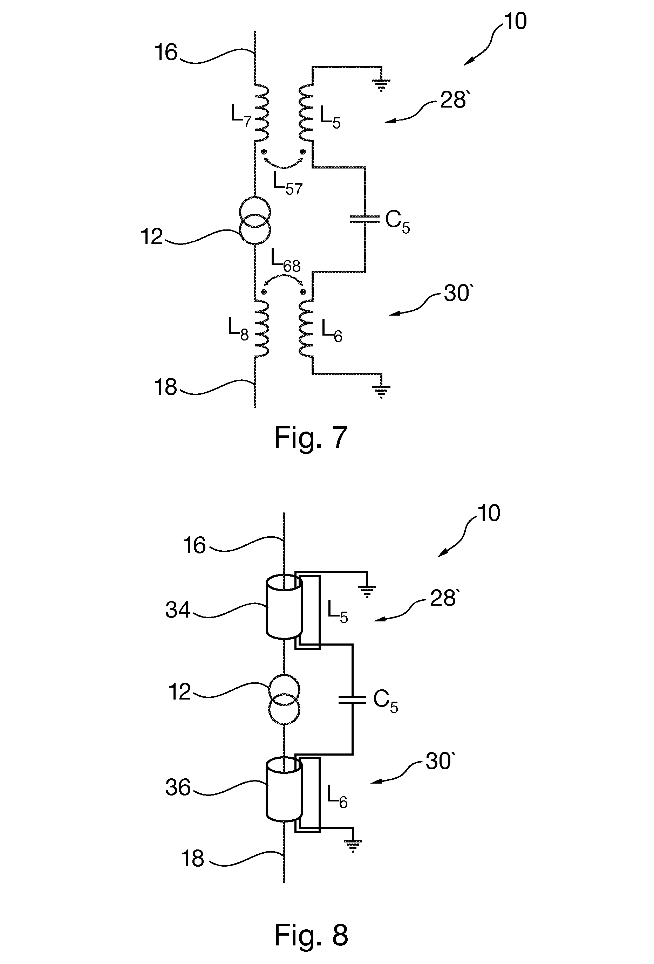

A 0 dB gain through the bypass 14 implies that the voltage amplitude of the high frequency power line communication signal is the same at the transformer output than at the input. Depending on the power line communication transceivers, it may be preferable that the amplitude of the high frequency power line communication signal is a fixed fraction of the voltage of the AC power, implying a same desired gain of-34 dB in Fig. 7 for both the 50 Hz AC power and the 50 kHz power line communication signal. This can also be achieved by proper selection of parameters.

For example the fraction may be 5%. 5% of 20 kV at medium voltage corresponds to 1000 V. It may not be desirable to have a power line communication signal of 1000 V amplitude on the LV side at 400 V.)

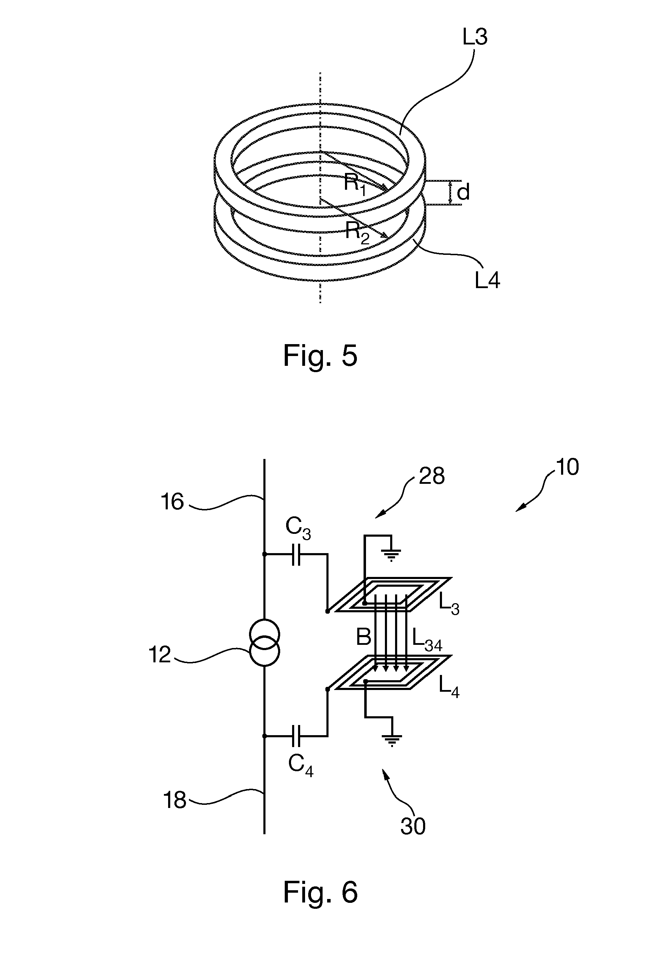

Fig. 4 and 5 show two embodiments of the coils L₃, L₄ for the high frequency bypass 14.

In order to have rather small and cheap coils, the system may be designed in such a way that line frequency (for example 50Hz) voltage almost fully drops across the capacitors C₃ and C₄. At 50 Hz the impedances (ωC) of the capacitors C₃ and C₄ may have kOhm or MOhm values. They become comparable to resistors only at the desired high frequency range (for example higher than 10 kHz) so that the dielectric issues do not influence the design of the coils L₃, L₄, for example the clearance distance between the coils L₃, L₄ (see Fig. 4 and 5). Since in this case the coils L₃, L₄ are not exposed to the line frequency high voltage but only to the high frequency low voltage, they can have a very small number of turns. Furthermore, since the transmitted high frequency power is expected to be also small (for example smaller than 100 W) the coil conductors could also be thin and hence cheap.

Fig. 4 shows two coils L₃, L₄ that are concentric and coplanar and have different radiuses R₁, R₂. Two concentric coplanar coils L₃, L₄ with different radiuses R₁, R₂ may be recommended if the required inductances of the coils L₃, L₄ are very different. Cylindrical coils L₃, L₄ are easy to manufacture, have low dielectric problems (no sharp corners), and have good mechanical stability. Different inductances of the coils L₃, L₄ may be beneficial, if a special shape of the frequency characteristic is needed.

Fig. 5 shows two coils L₃, L₄ that are concentric and are lying in parallel planes. The coils L₃, L₄ have equal radiuses R₁, R₂. Two concentric coils L₃, L₄ with parallel planes are suggested, if the required inductances of the coils L₃, L₄ are the same. In particular, R₁ = R₂ = 260mm, the number of windings of each coil L₃, L₄ is 10, the thickness of each coil is 50mm, the distance d of the coils is 50mm, and the height of each coil is 100mm.

In the embodiments of Fig. 4 and 5, the coupling coefficient k₃₄ may be controlled by the distance d. However, if the shape of the frequency characteristic shown in Fig. 3 is good enough, the required inductances of the coils L₃, L₄ are the same and the embodiment of Fig. 5 may be used.

The coils L₃, L₄ of Fig. 4 or Fig. 5 may be cast into epoxy and may be made mechanically very stable. The other component of the bypass 14 may be chosen as standard components, for example capacitors C₃ = C₄ = 70nF, resistors R₃ = R₄ = 300 Ω, R₅= R₆= 2 Ω are available as standard components.

Fig. 6 shows a simplified embodiment of a bypass 14 with respect to the embodiment of Fig. 2. The bypasss 14 of Fig. 6 comprises a system of at least two magnetically coupled coils L5, L6 connected in two series resonant LC circuits 28, 30. The two resonant circuits 28, 30 are directly (solidly) connected to the power lines 16, 18 over the capacitors C3, C4, respectively. On their other side, the resonant circuits 28, 30 are directly grounded.

Fig 7 and Fig. 8 show a bypass 14 with two inductor L₅ and L₆ connected in series. The two inductors L₅, L₆ may be interconnected with a capacitor C₅. The bypass 14 is coupled via the first inductor L5 to the first power line 16 and is coupled via the second inductor L6 to the second power line 18.

It has to be noted that the inductor L₅, the capacitor C₅ and the inductor L₆ may be seen as one resonant circuit or as two resonant circuits 28', 30' that share one common capacitor C₅. The first resonant circuit 28' comprises the first inductor L₅ and the capacitor C₅ connected in series. The second resonant circuit 30' comprises the capacitor C₅ and the second inductor L₆ connected in series.

In the embodiment of Fig. 7, the bypass 14 comprises an inductor L₇ in the first power line 16 and an inductor L₈ in the second power line 18. The inductor L₇ is magnetically coupled to the inductor L₅ and the inductor L₈ is magnetically coupled to the inductor L₆. Each pair of inductors (for example L₅, L₇) may be combined with a ferrite cylinder for better magnetic coupling. The bypass of Fig. 7 is therefore a high frequency bypass comprising four coils L₅, L₆, L₇, L₈ and only one capacitor C₅.

In the embodiment of Fig. 8, the bypass 14 comprises no inductors in the first power line 16 and second power line 18. The inductor L₅ is magnetically coupled to the power line 16 via a ferrite cylinder 34. The inductor L₆ is magnetically coupled to the second power line 18 via a ferrite cylinder 36. The ferrite cylinder 34, 38, may surround the power line 16, 18 and a part of the coil L₅, L₆. The bypass of Fig. 8 may have only two coils L₅, L₆ and only one capacitor C₅.

Furthermore, the bypasss 14 of Fig. 6, 7, 8 have symmetric circuits with respect to their connection or coupling to the first power line 16 and the second power line 18, i..e the bypass 14 are symmetrically designed with respect to the first power line 16 and the second power line 18.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

## Claims

1. A high frequency bypass (14) for bypassing a transformer (12) operating at a line frequency and coupling a first power line (16) and a second power line (18),
wherein the bypass (14) comprises a resonant circuit (28, 30) comprising an inductor (L₃) and a capacitor (C₃);
wherein the bypass (14) is adapted to be electrically coupled with the first power line (16) and the second power line (18) and to provide a galvanic insulation between the first power line (16) and the second power line (18);
wherein the resonant circuit (28, 30) is tuned to a high frequency range above the line frequency.

2. The bypass (14) of claim 1,
wherein the bypass is adapted to be capacitively coupled via the capacitor (C₃, C₄) to the first power line (16) or the second power line (18).

3. The bypass (14) of claim 1,
wherein the bypass is adapted to be inductively coupled via an inductor (L₅, L₆) to the first power line (16) or the second power line (18) for galvanically separating the first power line (16) and the second power line (18).

4. The bypass (14) of claim 3,
wherein the inductor (L₅) is adapted to be coupled via air to a further inductor (L₇) in the first power line or the second power line (18); and/or
wherein the inductor (L₅) is adapted to be coupled via a ferrite cylinder (34) to the first power line (16) or the second power line (18).

5. The bypass (14) of claim 4,
wherein the bypass (14) comprises two resonant circuits (28', 30') which are coupled via a shared capacitor (C₅).

6. The bypass (14) of claim 2,
wherein the bypass (14) comprises two resonant circuits (28, 30) which are coupled via two inductors (L₃, L₄) for galvanically separating the first power line (16, 18) and the second power line.

7. The bypass (14) of claim 6,
wherein the two inductors (L₃, L₄) are coupled via air; and/or
wherein the two inductors (L₃, L₄) are coupled via a ferrite cylinder.

8. The bypass (14) of claim 6 or claim 7,
wherein the two inductors are two coils (L₃, L₄),
wherein the two coils (L₃, L₄) are concentric coplanar coils with different radiuses; or wherein the two coils (L₃, L₄) are concentric coils with parallel planes and equal radiuses.

9. The bypass (14) of one of claims 5 to 8,
wherein the two resonant circuits (28, 30) are directly connected to the power lines (16, 18).

10. The bypass (14) of one of the preceding claims,
wherein the inductor (L₃) and the capacitor (C₃) are connected in series.

11. The bypass (14) of one of the preceding claims,
wherein the resonant circuit (28, 30) comprises a resistor (R₃) connected in parallel with the inductor (L₃) and/or a resistor (R₅) interconnecting the inductor (L₃) with the ground.

12. The bypass (14) of one of the preceding claims,
wherein a first resonant circuit (28') comprises a first inductor (L₅) and a capacitor (C₅) connected in series;
wherein a second resonant circuit (30') comprises the capacitor (C₅) and a second inductor (L₆) connected in series;
wherein the first resonant circuit (28') is coupled via the first inductor (L₅) to the first power line (16) and the second resonant circuit (30') is coupled via the second inductor (L₆) to the second power line (18).

13. The bypass (14) of one of the preceding claims,
wherein the bypass (14) is symmetrically designed with respect to the first power line (16) and the second power line (18).

14. A system (10) for transmission of electrical energy and for data communication, comprising:
a power transformer (12) interconnecting a first power line (16) and second power line (18) and adapted for transforming a first voltage in the first power line (16) into a second voltage in the second power line (18);
a bypass (14) according to one of the claims 1 to 13 interconnecting the first power line (16) and the second power line (18) and transmitting a high frequency data signal (24) between the first power line (16) and the second power line (18).
